# EUROPÄISCHE PATENTANMELDUNG

(11) **EP 0 614 277 A1**
(43) Veröffentlichungstag der Anmeldung: **07.09.1994**
(21) Anmeldenummer: 94102785.6
(22) Anmeldetag: 24.02.1994
(51) Int. Cl.: H03K 5/13

(54) **Schaltungsanordnung für eine Verzögerungsleitung in integrierten CMOS-Schaltungen**

(30) Priorität: 27.02.1993 DE 4306201
(71) Anmelder: Alcatel SEL Aktiengesellschaft, D-70435 Stuttgart (DE)
(72) Erfinder: Banniza, Thomas, D-71282 Hemmingen (DE)
(74) Vertreter: Müller, Joachim

(57) **Zusammenfassung**

Verzögerungsschaltungen aus einer Kettenschaltung von Gattern haben als CMOS-Schaltungen den Nachteil, daß die typische Verzögerungszeit eines CMOS-Gatters bis zu einem Faktor zwischen 0,5 und 2,0 als Funktion von Temperaturänderungen und Betriebsspannungsänderungen sowie von Änderungen der Prozeßgeschwindigkeit abweicht und damit einen großen Toleranzbereich der Verzögerungszeit einer Verzögerungsschaltung bedingt. Die Verzögerungszeit wird im wesentlichen vom RC-Produkt des dynamischen Ausgangswiderstandes des treibenden Gatters und der Eingangskapazität des getriebenen Gatters bestimmt. Erfindungsgemäß wird durch Konstantstromquellen, realisiert durch Stromspiegelschaltungen, der Ausgangsstrom eines CMOS-Gatters bei unterschiedlichen Betriebsbedingungen konstant gehalten. Damit bleibt auch der Ausgangswiderstand konstant und der Toleranzbereich der Gatterlaufzeit wird damit wesentlich eingeschränkt. Somit läßt sich eine Verzögerungsschaltung in CMOS-Technik mit engen Toleranzen herstellen, wobei auf nicht CMOS-typische Effekte und kostenaufwendige herstellerspezifische Zusatzprozesse verzichtet wird.

## Beschreibung

Die Erfindung betrifft eine Schaltungsanordnung für eine Verzögerungsschaltung in integrierten CMOS-Schaltungen, die beispielsweise zur Anpassung der Phase eines Taktes an die zeitliche Lage eines Datensignals oder umgekehrt benötigt wird.

Es ist allgemein bekannt, Verzögerungsschaltungen in Digitaltechnik als Kettenschaltung aus Invertern oder Buffern zu bilden, wobei gegebenenfalls Abgriffe von dieser Verzögerungsschaltung an einen Multiplexer geführt sind, um eine einstellbare Verzögerungszeit zu erhalten. Die erreichbare Genauigkeit und Konstanz der Verzögerungszeiten wird bei integrierten CMOS-Bauelementen wesentlich durch Prozeßschwankungen sowie Temperatur- und Spannungsschwankungen beeinflußt, da davon die Gatterlaufzeit eines Signals in einer CMOS-Schaltung abhängig ist. Je nach Hersteller muß eine Abweichung von bis zu einem Faktor zwischen 0,5 und 2,0 von der typischen Verzögerungszeit eines CMOS-Gatters oder einer kombinatorischen Schaltung aus CMOS-Gattern beim Schaltungsentwurf berücksichtigt werden. Bei synchronen Schaltnetzwerken wird die gewünschte Funktion der Schaltung bis zu einer maximalen Betriebsfrequenz, die sich aus der maximalen Laufzeit eines Signals beispielsweise von einem Registerausgang durch die Logikschaltung zum nächsten Registereingang ergibt, sichergestellt. Bei Verzögerungsleitungen ist die Schwankung der CMOS-Gatterlaufzeiten oft nachteilig, da mit der Verzögerungsleitung üblicherweise eine Verzögerungszeit erreicht werden soll, die durch ein externes, in der Regel prozeßunabhängiges, definiertes Zeitfenster vorgegeben ist.

Die Variation der Laufzeiten bei CMOS-Gattern ist aber physikalisch bedingt. Die Laufzeit wird bestimmt vom Ausgangswiderstand des treibenden CMOS-Gatters und von der Eingangskapazität des getriebenen CMOS-Gatters. Die Steilheit der verwendeten CMOS-Tansistoren hat Einfluß auf den dynamischen Ausgangswiderstand und den Strom, den ein CMOS-Transistor bei gegebener Gate- und Drain-Source-Spannung liefern kann. Der dynamische Ausgangswiderstand wird kleiner, wenn der Prozeß schneller wird, die Temperatur sinkt oder die Betriebsspannung steigt. Zwar wird die Eingangskapazität größer, wenn der Prozeß schneller wird, dennoch kompensieren sich Abnahme des dynamischen Ausgangswiderstandes und Zunahme der Eingangskapazität bei der Zeitkonstanten nicht, da der Einfluß des dynamischen Ausgangswiderstandes den der Eingangskapazität deutlich überwiegt. Änderungen der Temperatur oder der Betriebsspannung haben nur einen untergeordneten Einfluß auf die Eingangskapazität.

Eine Einschränkung des Variationsbereiches der CMOS-Gatterlaufzeit ist nur möglich, wenn bei der Herstellung der CMOS-Gatter besondere Maßnahmen, wie beispielsweise Steuerung der Implantation auf Kosten der Gesamtausbeute, vorgesehen sind. Ansonsten ist es möglich, enger tolerierte Verzögerungszeiten mit Analogschaltungen zu erreichen. Das bedingt jedoch eine Abweichung von einheitlicher Technologie und erfordert für analoge Spannungen zusätzliche Anschlußmöglichkeiten an der integrierten Schaltung.

Aufgabe der Erfindung ist es, eine Schaltungsanordnung für eine Verzögerungsleitung oder für ein Verzögerungsleitungselement anzugeben, die sich einerseits mit einem üblichen CMOS-Prozeß fertigen läßt und andererseits die sonst bei CMOS-Schaltungen auftretenden großen Gatterlaufzeitabweichungen vom typischen Mittelwert bei Prozeßschwankungen sowie Temperatur- und Spannungsschwankungen vermeidet. Auf nicht CMOS-typische Effekte oder kostenaufwendige herstellerspezifische Zusatzprozesse soll verzichtet werden.

Diese Aufgabe wird erfindungsgemäß durch die im Hauptanspruch angegebenen Merkmale der Schaltungsanordnung gelöst. Realisierungsvarianten sind in den Unteransprüchen angegeben.

Die erfindungsgemäße Schaltungsanordnung ermöglicht eine wesentliche Reduzierung des Toleranzbereichs der Gatterlaufzeit, ohne dem Halbleiterhersteller besondere technologische Forderungen zu stellen. Durch die Schaltungsanordnung wird erreicht, daß der Strom, der im Ausgangskreis eines Gatters fließt, annähernd konstant gehalten werden kann. Folglich bleibt auch der dynamische Ausgangswiderstand annähernd konstant, so daß lediglich die Änderungen der Eingangskapazität des getriebenen Gatters Einfluß auf die Gatterlaufzeit haben. Mit der Schaltungsanordnung wird der Aufbau integrierter Verzögerungsleitungen in CMOS-Schaltungen wesentlich einfacher und ihr Einsatz im Hochgeschwindigkeitsbereich überhaupt erst möglich.

Die Erfindung wird nachstehend an einem Ausführungsbeispiel erläutert. In der dazugehörigen Zeichnung zeigen
- Fig. 1: ein Schaltbild eines Ausschnitts einer Verzögerungsleitung nach dem bekannten Stand der Technik,
- Fig. 2: ein Schaltbild einer Stromspiegelschaltung nach dem bekannten Stand der Technik,
- Fig. 3: ein Schaltbild einer erfindungsgemäßen Schaltungsanordnung für drei Elemente einer Verzögerungsleitung und
- Fig. 4: ein Schaltbild mit mehreren Verzögerungsleitungen und einem Regelkreis zur Erzeugung der Steuerspannungen VP und VN.

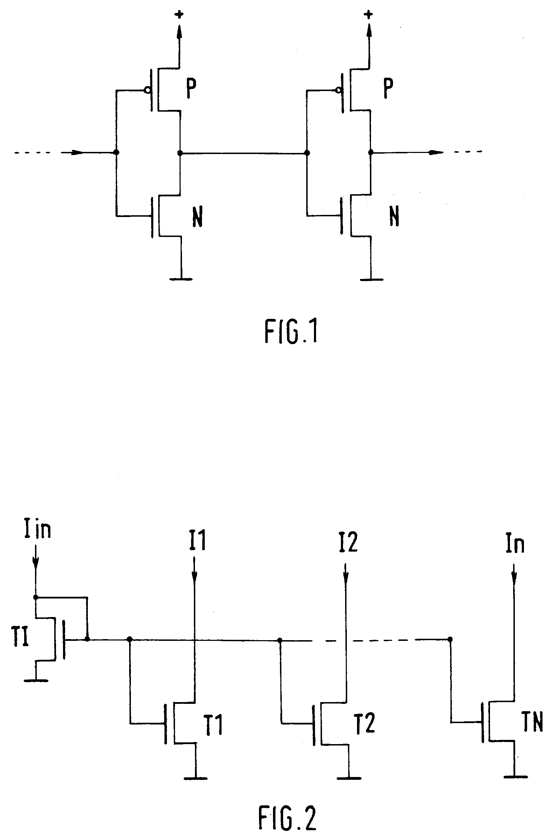

Gemäß Fig. 1 besteht eine bekannte Verzögerungsleitung aus der Kettenschaltung mindestens zweier CMOS-Gatter. In dieser Schaltung sind die Transistoren jeweils vollständig leitend oder gesperrt, wie das in der CMOS-Schaltungstechnik typisch ist. Infolgedessen wirken sich auch alle Schwankungen des Ausgangswiderstandes der treibenden Stufe auf die Verzögerungszeit der Verzögerungsleitung aus, da sich die Verzögerungszeit überwiegend aus dem RC-Produkt von Ausgangswiderstand der treibenden Stufe und Eingangskapazität der getriebenen Stufe ergibt.

Fig. 2 zeigt eine Stromspiegelschaltung in CMOS-Schaltungstechnik mit n-Kanal-Transistoren. Mit derartigen Schaltungen ist es möglich, Ströme definiert in einer integrierten Schaltung zu verteilen und konstant zu halten. Die Stromspiegelschaltung besteht aus einer Steuerschaltung mit einem Transistor TI und den folgenden Stromspiegeltransistoren T1...TN. Die Steuerschaltung, in die ein Referenzstrom Iin eingeprägt wird, prägt ihrerseits über eine an den Gates der Stromspiegeltransistoren T1...TN anliegenden Steuerspannung in die Stromspiegeltransistoren T1...TN jeweils einen Strom I1...In ein. Der eingeprägte Strom in einem Stromspiegeltransistor T1...TN ergibt sich aus dem Referenzstrom Iin multipliziert mit einem Faktor, der sich aus möglichen Geometrieunterschieden der jeweiligen Stromspiegeltransistoren T1...TN ergibt. Dieser Faktor ist ausschließlich abhängig von der Reproduzierbarkeit der geometrischen Strukturen des Layouts. Durch unterschiedliche Geometrien können von einem Referenzstrom unterschiedlich große Ströme in die Stromspiegeltransistoren eingeprägt werden. Voraussetzung ist, daß die Schaltung im linearen Bereich arbeitet, wenn sie aktiv ist. Das ist beim Schaltungsentwurf durch entsprechende Dimensionierung der Transistoren problemlos zu erreichen.

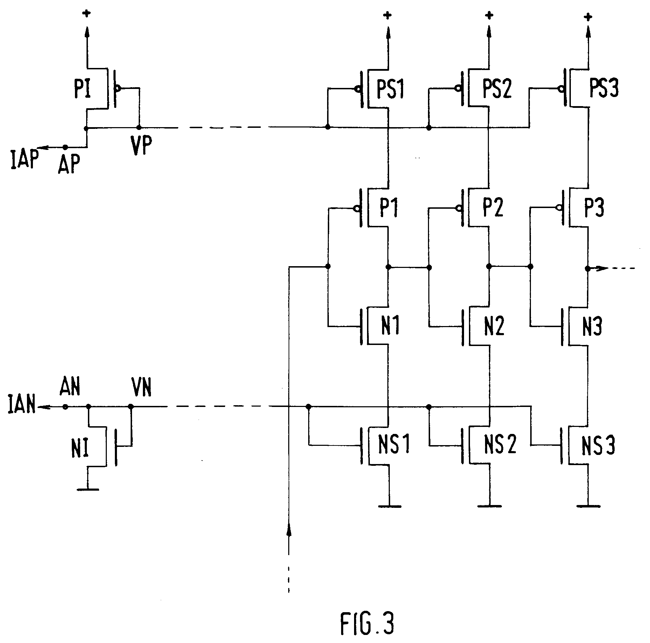

In Fig. 3 sind die ersten drei Elemente einer Verzögerungsleitung dargestellt. Gemäß Fig. 3 besteht die erfindungsgemäße Schaltungsanordnung aus einer ersten Steuerschaltung mit einem ersten Transistor PI, einer zweiten Steuerschaltung mit einem zweiten Transistor NI, aus den p-Kanal-Schalttransistoren P1...P3 und den n-Kanal-Schalttransistoren N1...N3 der CMOS-Gatter sowie den jeweils diesen Schalttransitoren zugeordneten Stromspiegeltransistoren PS1...PS3, NS1...NS3. Die p-Kanal-Schalttransistoren und n-Kanal-Schalttransistoren sind so zu dimensionieren, daß ihr Durchgangswiderstand klein gegenüber dem Ausgangswiderstand der von den Stromspiegeltransistoren PS1...PS3, NS1...NS3 gebildeten Stromquellen ist. Am Anschluß AP der ersten Steuerschaltung wird ein erster Referenzstrom IAP eingeprägt und erzeugt an dem ersten Transistor PI eine erste Steuerspannung VP, am Anschluß AN der zweiten Steuerschaltung wird ein zweiter Referenzstrom IAN eingeprägt und erzeugt an dem zweiten Transistor NI eine zweite Steuerspannung VN. Es ist zweckmäßig, die erste und zweite Steuerspannung VP, VN an einer Stelle der integrierten Schaltung zentral zu erzeugen und sie dann an die Gates der Stromspiegeltransistoren PS1...PS3, NS1...NS3 zu führen. Der erste und zweite Referenzstrom IAP, IAN werden zweckmäßigerweise außerhalb der integrierten Schaltung erzeugt und dann der Schaltung zugeführt. Damit unsymmetrische Verzerrungen des zu verzögernden Signals vermieden werden, wird jeweils der Betrag des ersten und zweiten Referenzstromes IAP, IAN gleich gewählt.

Mit der Schaltungsanordnung wird erreicht, daß der Strom, der durch den Ausgang eines CMOS-Gatters fließt, im wesentlichen konstant gehalten werden kann. Damit ist die Gatterlaufzeit dann nur noch von der Änderung der Eingangskapazität abhängig. Die Abweichung vom typischen Wert der Gatterlaufzeit wird von worst case : best case = 2,0 : 0,5 auf 1,2 : 0,8 eingeschränkt, das heißt mit der Schaltungsanordnung wird eine gegenüber bekannten Schaltungslösungen enger tolerierte Logiklaufzeit erreicht.

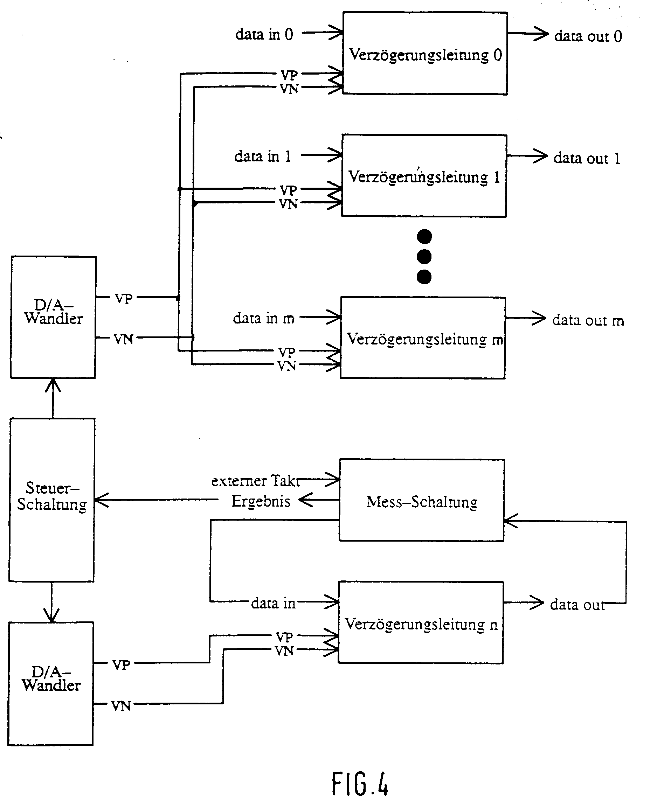

Es ist möglich, den Toleranzbereich weiter zu verkleinern, indem der beschriebene Stellmechanismus für die erste Steuerspannung VP und die zweite Steuerspannung VN zu einer Regelschleife erweitert wird, vgl. Fig. 4. Dazu wird zusätzlich zu den in einer Baugruppe für die gewünschten Funktionen eingebauten Verzögerungsleitungen 0 bis m eine Verzögerungsleitung n vorgesehen, deren Laufzeit mit einer Meßschaltung ausgemessen wird. Die Messung der Laufzeit erfolgt beispielsweise durch Vergleich der Laufzeit mit der Periode eines externen Taktes oder durch Bestimmung der Frequenz eines Ringoszillators, in dem die Verzögerungsleitung n das frequenzbestimmende Element ist. Eine Steuerschaltung steuert den Strom in der Verzögerungsleitung n in der Weise, daß die Laufzeit in dieser Verzögerungsleitung n dem gewünschten Wert möglichst nahe kommt. Der so ermittelte Strom wird dann zur Steuerung der Verzögerungsleitungen 0 bis m verwendet, die für die Funktion der Baugruppe benötigt werden.

Die Steuerschaltung wird zweckmäßigerweise als digitales Steuerwerk aufgebaut. Über D/A-Wandler werden dann die erste Steuerspannung VP und die zweite Steuerspannung VN erzeugt. Dabei ist es möglich, einen zentralen D/A-Wandler für die Verzögerungsleitungen 0 bis m der Baugruppe und einen D/A-Wandler für die Verzögerungsleitung n vorzusehen und dann die analogen Steuerspannungen zu verteilen oder aber jeder Verzögerungsleitung einen separaten D/A-Wandler zuzuordnen. Letzteres ist vorzuziehen, da die Verteilung eines digitalen Steuersignals störsicherer ist als die eines analogen Steuersignals.

Der Stellmechanismus kann nur während der Initialisierung der Baugruppe arbeiten. Er wird durch einen externen Taktimpuls oder durch eine Taktimpulsfolge ausgelöst. Soll der Regelkreis auch während des regulären Betriebes arbeiten, ist durch Auswahl eines geeigneten Steuerungsablaufs und einer geeigneten D/A-Wandler-Struktur sicherzustellen, daß durch den Regelvorgang keine Störsignale in das Nutzsignal der Verzögerungsleitungen eingestreut werden.

## Patentansprüche

1. Schaltungsanordnung für eine Verzögerungsleitung aus einer Kettenschaltung aus CMOS-Gattern in integrierten CMOS-Schaltungen, **dadurch gekennzeichnet,** daß Mittel vorgesehen sind, die den Ausgangsstrom der Schalttransistoren eines CMOS-Gatters konstant halten.

2. Schaltungsanordnung nach Anspruch 1, dadurch gekennzeichnet, daß ein p-Kanal-Schalttransistor (P1...Pn) und ein n-Kanal-Schalttransistor (N1...Nn) jeweils mit einem Stromspiegeltransistor (PS1...PSn und NS1...NSn) einer Stromspiegelschaltung in Reihe geschaltet sind.

3. Schaltungsanordnung nach Anspruch 2, dadurch gekennzeichnet, daß die Stromspiegelschaltung eine Steuerschaltung enthält, deren erster, eine erste Steuerspannung (VP) führender Ausgang mit den Gates der p-Kanal-Stromspiegeltransistoren (PS1...PSn) und deren zweiter, eine zweite Steuerspannung (VN) führender Ausgang mit den Gates der n-Kanal-Stromspiegeltransistoren (NS1...NSn) verbunden ist.

4. Schaltungsanordnung nach Anspruch 3, dadurch gekennzeichnet, daß die Größe der ersten Steuerspannung (VP) und der zweiten Steuerspannung (VN) von einem Regelkreis bestimmt werden, der eine Verzögerungsleitung und eine Meßschaltung enthält.
